# EUROPÄISCHE PATENTSCHRIFT

(11) **EP 3 499 245 B1**
(45) Veröffentlichungstag und Bekanntmachung des Hinweises auf die Patenterteilung: **03.06.2020**
(21) Anmeldenummer: 18207765.1
(22) Anmeldetag: 22.11.2018
(51) Int. Cl.: G01R 1/20, H01C 3/02

(54) **ANORDNUNG MIT KOAXIALWIDERSTAND**
ASSEMBLY WITH COAXIAL RESISTANCE
AGENCEMENT À RÉSISTANCE COAXIALE

(30) Priorität: 12.12.2017 DE 102017222479
(43) Veröffentlichungstag der Anmeldung: 19.06.2019
(73) Patentinhaber: Siemens Aktiengesellschaft, 80333 München (DE)
(72) Erfinder: Delchmann, Wilhelm, 91093 Heßdorf (DE); Hofstetter, Michael, 81371 München (DE); Philipp, Andreas, 90610 Winkelhaid (DE); Zorawik, Michael, 91352 Hallerndorf (DE)

(56) Entgegenhaltungen:
- WO-A1-2010/088908
- CN-A- 106 950 525
- DE-A1- 19 854 436
- DE-U1-202005 019 484
- DE-U1-202010 010 152
- FR-A1- 2 348 498
- FR-A5- 2 044 459
- GB-A- 1 424 984
- JP-A- 2003 315 371

## Beschreibung

In Hochspannungsanlagen, insbesondere solchen zur Hochspannungsgleichstromübertragung, wird üblicherweise an verschiedenen Stellen der Strom gemessen. Der Strom kann dabei eine Gleich- oder Wechselgröße oder eine Kombination aus beiden Formen sein. Insbesondere bei VSC-basierten (spannungsgeführten) Anlagen zur Hochspannungsgleichstromübertragung gibt es eine hohe Anforderung an die Dynamik des Messsystems, da eine Messung hochfrequenter Ströme bis zu 50 kHz wünschenswert ist. Problematisch ist nun, dass in der Hochspannungsanlage mit Störungen durch elektromagnetische Felder hoher Feldstärke zu rechnen ist.

Eine Anordnung mit einem Koaxialwiderstand ist beispielsweise aus der internationalen Patentanmeldung WO 2017/068409 bekannt. Bei der vorbekannten Anordnung ist ein Widerstandsring zur Erzeugung eines elektrischen Messsignals im Außenbereich des Koaxialwiderstands angeordnet.

Ein artgemäßer Koaxialwiderstand ist aus der DE 20 2005 019 484 U1 bekannt.

Der Erfindung liegt die Aufgabe zugrunde, eine Anordnung mit einem Koaxialwiderstand anzugeben, mit der eine besonders störungsfreie Erzeugung von Messsignalen möglich ist.

Diese Aufgabe wird erfindungsgemäß durch eine Anordnung mit den Merkmalen gemäß Patentanspruch 1 gelöst. Vorteilhafte Ausgestaltungen der erfindungsgemäßen Anordnung sind in Unteransprüchen angegeben.

Danach ist erfindungsgemäß vorgesehen, dass der Koaxialwiderstand auf einem elektrisch leitfähigen Gehäuse aufgesetzt ist und Sensorleitungen des Koaxialwiderstands durch einen Innenraum des Koaxialwiderstands hindurch in das Innere des Gehäuses geführt sind und mit einer in dem Gehäuse befindlichen elektrischen Schnittstelle verbunden sind.

Ein wesentlicher Vorteil der erfindungsgemäßen Anordnung ist darin zu sehen, dass die Sensorleitungen im Innenbereich des Koaxialwiderstands geführt werden, so dass die Sensorleitungen und damit die darauf geführten Messsignale durch den Koaxialwiderstand vor äußeren Einflüssen, insbesondere elektromagnetischen Wellen oder Strahlung, abgeschirmt werden.

Bei der elektrischen Schnittstelle handelt es sich vorzugsweise um eine Messeinrichtung, wenn bereits im Gehäuse Messwerte erzeugt werden sollen. Die Messwerte können beispielsweise im Gehäuse abgespeichert oder ausgegeben werden. Die Ausgabe erfolgt vorzugsweise optisch, beispielsweise mittels eines oder mehrerer Lichtwellenleiter, denn Lichtwellenleiter ermöglichen in vorteilhafter Weise eine Potentialtrennung zwischen der elektrischen Schnittstelle und einer die Messwerte von dieser erhaltenden Empfangseinrichtung.

Alternativ wird es als vorteilhaft angesehen, wenn es sich bei der elektrischen Schnittstelle lediglich um einen elektooptischen Wandler handelt, der im Gehäuse nur eine Wandlung des oder der elektrischen Messsignale in optische Messsignale als Ausgangssignal vornimmt und diese mittels eines oder mehrerer Lichtwellenleiter nach außen ausgibt.

Bezüglich des Aufbaus des Koaxialwiderstands weist dieser einen äußeren Hohlleiter und einen in dem äußeren Hohlleiter koaxial angeordneten und von diesem durch einen Spalt getrennten inneren Hohlleiter auf. Der innere Hohlleiter weist vorzugsweise zumindest zwei Ringsegmente auf, von denen mindestens eines ein Widerstandring ist, der mit den Sensorleitungen oder zumindest zwei der Sensorleitungen in Verbindung steht.

Besonders vorteilhaft ist es, wenn der innere Hohlleiter zumindest drei Ringsegmente aufweist, wobei einer von diesen ein gehäusenaher Hohlleiterabschnitt, einer ein gehäuseferner Hohlleiterabschnitt und einer ein Widerstandsring zwischen dem gehäusefernen und dem gehäusenahen Hohlleiterabschnitt ist.

Die Ringsegmente sind bezogen auf ihre Außenkontur und ihre Innenkontur im Querschnitt vorzugsweise kreisrund, jedoch sind alternativ auch andere Außenkonturen und Innenkonturen (z. B. elliptisch, eckig, etc.) denkbar. Vorteilhaft ist es jedoch, wenn die Innenkontur derart ausgebildet ist, dass die Sensorleitungen durch den Innenkonturbereich hindurchgeführt werden können.

Auch ist es vorteilhaft, zur Erzeugung einer Mehrzahl an Messsignalen zwei oder mehrere Widerstandsringe im inneren Hohlleiter vorzusehen. Die Sensorleitungen werden auch bei dieser Ausgestaltung durch den Innenraum des Koaxialwiderstands hindurch in das Innere des Gehäuses geführt.

Bezüglich des mechanischen Aufbaus ist es vorteilhaft, wenn ein innerer Abschnitt eines Stützelements des Koaxialwiderstands ein Ringsegment des inneren Hohlleiters, insbesondere den gehäusenahen Hohlleiterabschnitt, bildet und ein äußerer Abschnitt des Stützelements ein äußeres Ringelement des äußeren Hohlleiters stützt.

Der Koaxialwiderstand ist bevorzugt auf dem Gehäuse aufgeflanscht. Vorteilhaft ist es, wenn ein Abschnitt des genannten Stützelements einen Abschnitt, insbesondere Flanschabschnitt, bildet, der auf dem Gehäuse angeschraubt, insbesondere aufgeflanscht, ist.

Ein oder mehrere Abschirmelemente, insbesondere eine oder mehrere Abschirmplatten, bilden vorzugsweise gemeinsam mit dem leitfähigen Gehäuse und dem Koaxialwiderstand einen Faradaykäfig zumindest auch für den Widerstandsring, die Sensorleitungen und/oder die elektrische Schnittstelle.

Der Koaxialwiderstand und das Gehäuse werden vorzugsweise mittels einer Befestigungseinrichtung zwischen einem ersten Leiterende eines ersten Leiters einer Energieübertragungsleitung und einem dem ersten Leiterende gegenüber liegenden zweiten Leiterende eines zweiten Leiters derselben Energieübertragungsleitung gehalten, wobei die Befestigungseinrichtung mit einer ersten Klemmeinrichtung an dem ersten Leiterende und mit einer zweiten Klemmeinrichtung an dem zweiten Leiterende befestigt ist.

Die Befestigungseinrichtung dient vorzugsweise auch zur Stromführung zwischen den beiden Leiterenden.

Die erste Klemmeinrichtung weist vorzugsweise ein erstes Klemmelement und ein erstes Gegenklemmelement auf, die das erste Leiterende umfassen und zwischen sich einklemmen, und die zweite Klemmeinrichtung weist vorzugsweise ein zweites Klemmelement und ein zweites Gegenklemmelement auf, die das zweite Leiterende umfassen und zwischen sich einklemmen.

Der erste und zweite Leiter sind vorzugsweise jeweils Leiterrohre, die im Bereich des ersten und zweiten Leiterendes koaxial zueinander angeordnet sind.

Bezüglich der Befestigung wird es außerdem als vorteilhaft angesehen, wenn die Befestigungseinrichtung ein nichtleitendes Halteelement aufweist, auf dem das Gehäuse aufgesetzt ist. Der Koaxialwiderstand wird vorzugsweise von dem von der Befestigungseinrichtung gehaltenen Gehäuse gehalten. Der Koaxialwiderstand ist vorzugsweise auf der dem Halteelement abgewandten Seite des Gehäuses an dem Gehäuse angebracht.

Auch wird es als vorteilhaft angesehen, wenn die Befestigungseinrichtung mit einer ersten Anschlussschiene an einen elektrischen Anschluss des Koaxialwiderstands und mit einer zweiten Anschlussschiene an den anderen elektrischen Anschluss des Koaxialwiderstands angeschlossen ist, und die beiden Anschlussschienen der Befestigungseinrichtung den Koaxialwiderstand halten und der Koaxialwiderstand wiederum das Gehäuse hält. Bei dieser Ausgestaltung kann, muss aber nicht, auf das nichtleitende Halteelement verzichtet werden.

Eine elektrische Abschirmeinrichtung gegen Koronaentladung schirmt vorzugsweise den Koaxialwiderstand und das Gehäuse nach außen ab.

Die elektrische Abschirmeinrichtung ist vorzugsweise im Querschnitt elliptisch oder rund.

Die Längsachse der elektrischen Abschirmeinrichtung ist bevorzugt koaxial zu den beiden Leiterrohren - zumindest im Bereich der einander gegenüber liegenden Leiterenden - angeordnet.

Die Erfindung wird nachfolgend anhand von Ausführungsbeispielen näher erläutert; dabei zeigen beispielhaft
- Figur 1: ein Ausführungsbeispiel für eine erfindungsgemäße Anordnung, bei der ein Koaxialwiderstand und ein Gehäuse von einem Halteelement einer Befestigungseinrichtung gehalten werden,
- Figur 2: den Aufbau des Koaxialwiderstands der Anordnung gemäß Figur 1 näher im Detail,
- Figur 3: ein Ausführungsbeispiel für eine Abschirmplatte, die zur Bildung eines Faraday-Käfigs bei der Anordnung gemäß Figur 1 dienen kann,
- Figur 4: die Anordnung mit der Abschirmplatte gemäß Figur 3 im Querschnitt,
- Figur 5: ein Ausführungsbeispiel für eine erfindungsgemäße Anordnung, bei der ein Gehäuse von einem Koaxialwiderstand gehalten wird, der wiederum von lasttragenden Anschlussschienen einer Befestigungseinrichtung gehalten wird, und
- Figur 6: ein Ausführungsbeispiel für eine elektrisches Abschirmeinrichtung, die zum Abschirmen des Gehäuses und des Koaxialleiters bei den Anordnungen gemäß den Figuren 1 und 5 einsetzbar ist.

In den Figuren werden der Übersicht halber für identische oder vergleichbare Komponenten stets dieselben Bezugszeichen verwendet.

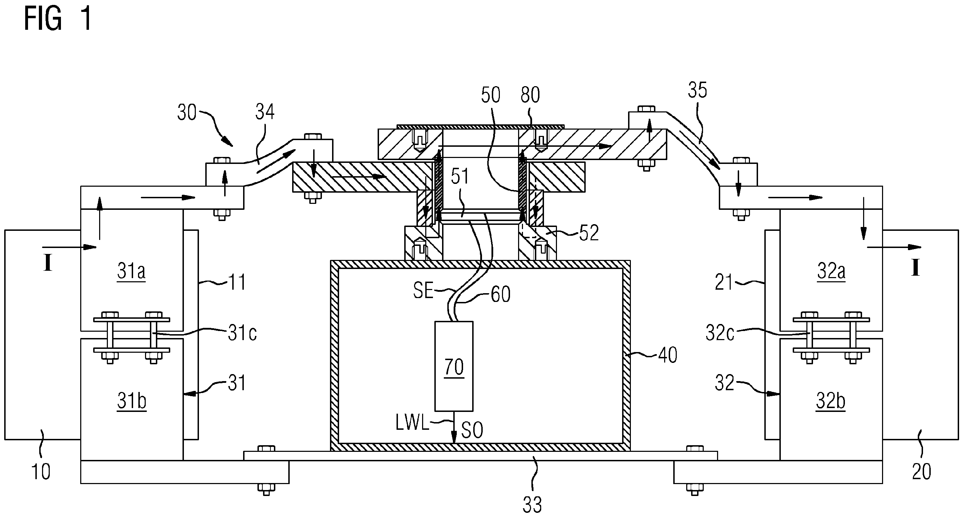

Die Figur 1 zeigt ein erstes Leiterrohr 10, dessen erstes Leiterende 11 einen Abstand zu einem zweiten Leiterende 21 eines zweiten Leiterrohres 20 aufweist. Die beiden Leiterrohre 10 und 20 sind vorzugsweise koaxial zueinander angeordnet und fluchten demgemäß.

Zwischen den beiden Leiterenden 11 und 21 der beiden Leiterrohre 10 und 20 hält eine Befestigungseinrichtung 30 ein elektrisch leitfähiges Gehäuse 40 mit einem darauf angebrachten Koaxialwiderstand 50. Der Koaxialwiderstand 50 weist ein Stützelement 52 auf, das zur Anbindung auf dem Gehäuse 40 dient.

Der Koaxialwiderstand 50 umfasst einen Widerstandsring 51, der mittels Sensorleitungen 60 mit einer elektrischen Schnittstelle 70 im Gehäuseinneren des elektrisch leitfähigen Gehäuses 40 verbunden ist. Die Sensorleitungen 60 sind durch einen hohlen Innenraum im Inneren des Koaxialwiderstands 50 geführt und werden somit durch den Koaxialwiderstand 50 und das Gehäuse 40 von äußeren Einwirkungen (z. B. elektrischen oder magnetischen Feldern) abgeschirmt.

Bei der elektrischen Schnittstelle 70 kann es sich um eine Messeinrichtung handeln, die ein elektrisches Messsignal SE der Sensorleitungen 60 misst und entsprechende Messwerte bildet. Die Messwerte können in der Messeinrichtung abgespeichert oder zum Beispiel mit einem optischen Ausgangssignal SO nach außen abgegeben werden. Das optische Ausgangssignal SO wird vorzugsweise über einen Lichtwellenleiter LWL aus einem dielektrischen Material zu einer in der Figur 1 nicht dargestellten und außerhalb des Gehäuses 40 angeordneten Empfängereinrichtung geleitet.

Alternativ kann es sich bei der elektrischen Schnittstelle 70 um einen elektrooptischen Umsetzer handeln, der das elektrische Messsignal SE lediglich in das optische Ausgangssignal SO wandelt und dieses über den Lichtwellenleiter LWL ausgibt.

Die Befestigungseinrichtung 30 weist zur Befestigung an dem ersten Leiterende 11 des ersten Leiterrohres 10 eine erste Klemmeinrichtung 31 auf, die ein erstes Klemmelement 31a und ein gegenüberliegendes erstes Gegenklemmelement 31b umfasst. Das Klemmelement 31a und das Gegenklemmelement 31b können durch Schellen gebildet sein, die mittels einer Schellenverschraubung 31c miteinander verschraubt sind.

Zur Anbindung an das zweite Leiterende 21 des zweiten Leiterrohres 20 weist die Befestigungseinrichtung 30 eine zweite Klemmeinrichtung 32 auf, die ein zweites Klemmelement 32a und ein zweites Gegenklemmelement 32b umfasst. Das zweite Klemmelement 32a und das zweite Gegenklemmelement 32b werden vorzugsweise durch Schellen gebildet, die durch eine Schellenverschraubung 32c miteinander verschraubt sind.

Die beiden Klemmeinrichtungen 31a und 32a können beispielsweise baugleich sein.

Bei dem Ausführungsbeispiel gemäß Figur 1 wird das Gehäuse 40 und damit der Koaxialwiderstand 50 von dem nichtleitenden Halteelement 33 der Befestigungseinrichtung 30 gehalten. Für den elektrischen Anschluss des Koaxialwiderstands 50 an die beiden Leiterrohre 10 und 20 dienen Anschlussschienen 34 und 35. Die Anschlussschienen 34 und 35 müssen lediglich zur Stromführung geeignet sein und brauchen keine mechanische Tragfähigkeit zum Halten oder Tragen des Koaxialwiderstands 50 oder des Gehäuses 40 aufzuweisen, da die letztgenannten Komponenten von dem Halteelement 33 getragen werden. Mit Blick auf die Aufnahme von mechanischen Verspannungen und dergleichen wird es als vorteilhaft angesehen, wenn die Anschlussschienen 34 und 35 mechanisch flexibel sind.

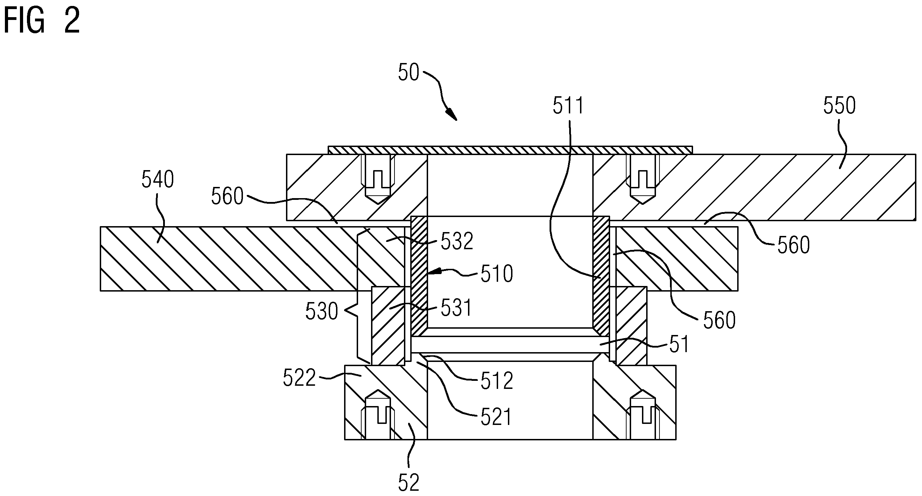

Die Figur 2 zeigt den Koaxialwiderstand 50 der Anordnung gemäß Figur 1 näher im Detail. Es lässt sich erkennen, dass der Koaxialwiderstand 50 einen inneren Hohlleiter 510 aufweist, der bei dem Ausführungsbeispiel gemäß Figur 1 durch einen gehäusefernen Hohlleiterabschnitt 511, den Widerstandsring 51 und einen gehäusenahen Hohlleiterabschnitt 512 gebildet ist.

Der gehäuseferne Hohlleiterabschnitt 511 wird vorzugsweise durch einen Metallring gebildet.

Der gehäusenahe Hohlleiterabschnitt 512 wird vorzugsweise durch einen vorstehenden inneren Abschnitt 521 des Stützelements 52 gebildet, mit dem der Koaxialwiderstand 50 auf dem Gehäuse 40 gemäß Figur 1 befestigt, insbesondere verschraubt, ist.

Ein äußerer Abschnitt 522 des Stützelements 52 dient zum Stützen eines äußeren Ringelements 531, das gemeinsam mit einem Endabschnitt 532 eines in der Figur 2 linken Anschlusselements 540 des Koaxialwiderstands 50 einen äußeren Hohlleiter 530 des Koaxialwiderstands 50 bildet. Das Stützelement 52 dient somit sowohl zum Abstützen des äußeren Hohlleiters 530 als auch zur elektrischen Verbindung zwischen dem äußeren Hohlleiter 530 und dem inneren Hohlleiter 510.

Um einen unmittelbaren Stromfluss zwischen dem in der Figur 2 linken Anschlusselement 540 und einem in der Figur 2 rechten Anschlusselement 550 des Koaxialwiderstands 50 zu vermeiden, ist zwischen den beiden Anschlusselementen 540 und 550 ein Spalt 560 (aus Luft oder einem nichtleitenden Material) vorgesehen, der sich auch zwischen den äußeren Hohlleiter 530 und den inneren Hohlleiter 510 erstreckt und somit den äußeren Hohlleiter 530 von dem inneren Hohlleiter 510 elektrisch trennt. Durch den Spalt 560 wird sichergestellt, dass ein durch den Koaxialwiderstand 50 fließender Strom I stets durch den Widerstandsring 51 fließen muss und diesen nicht passieren oder umgehen kann.

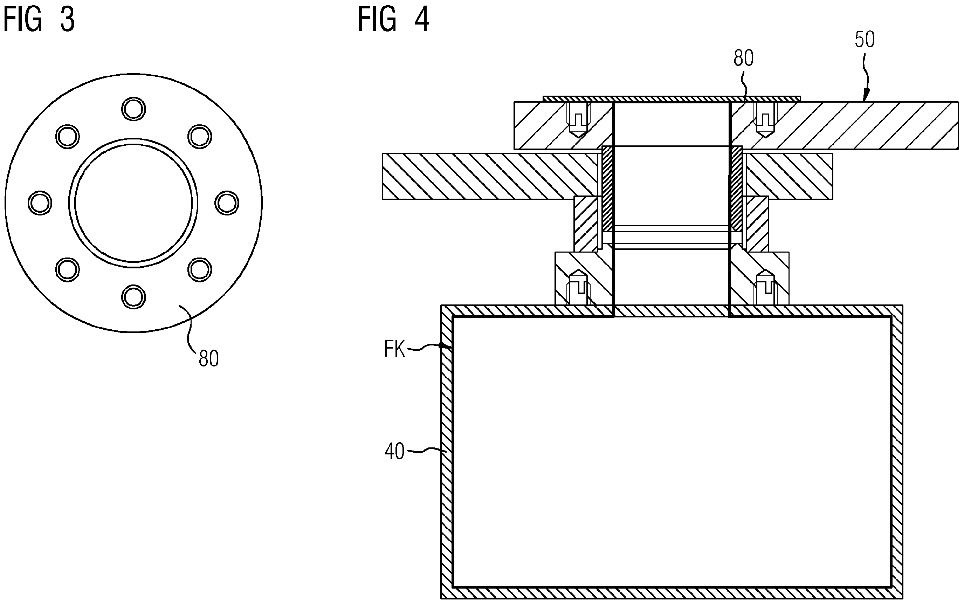

Die Figur 3 zeigt in der Draufsicht ein Ausführungsbeispiel für eine auch in der Figur 1 erkennbare, ein Abschirmelement bildende Abschirmplatte 80, die zur Bildung eines Faraday-Käfigs FK gemeinsam mit dem Koaxialwiderstand 50 und dem Gehäuse 40 dient.

Die Figur 4 zeigt in einem Querschnitt die Abschirmplatte 80 nach einer Montage auf dem Anschlusselement 550 des Koaxialwiderstands 50. Es lässt sich erkennen, dass die Abschirmplatte 80 den inneren Hohlraum des Koaxialwiderstands 50 nach oben hin abschließt, so dass der innere Hohlraum des Koaxialwiderstands 50 gemeinsam mit dem Gehäuseinneren des Gehäuses 40 einen nach außen hin elektromagnetisch abgeschirmten Faraday-Käfig FK bildet.

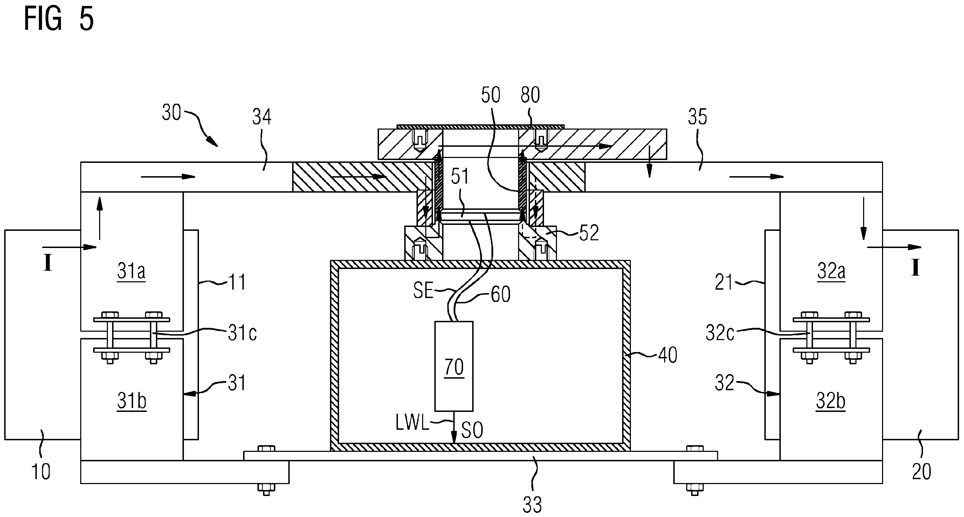

Die Figur 5 zeigt ein weiteres Ausführungsbeispiel für eine Anordnung mit einem Koaxialwiderstand 50 und einem Gehäuse 40, die gemeinsam zwischen den Leiterenden 11 und 21 zweier Leiterrohre 10 und 20 montiert sind. Zum Halten des Gehäuses 40 und des Koaxialwiderstands 50 dient eine Befestigungseinrichtung 30, die - im Unterschied zu dem Ausführungsbeispiel gemäß Figur 1 - kein nichtleitendes Halteelement 33 zum Halten des Gehäuses 40 aufweist. Statt dessen werden der Koaxialwiderstand 50 und das Gehäuse 40 allein durch die Anschlussschienen 34 und 35 der Befestigungseinrichtung 30 gehalten, die - im Unterschied zu dem Ausführungsbeispiel gemäß Figur 1 - nicht flexibel, sondern starr und tragfähig ausgebildet sind und somit allein in der Lage sind, sowohl den Koaxialwiderstand 50 als auch das Gehäuse 40 zwischen den beiden Leiterenden 11 und 21 der beiden Leiterrohre 10 und 20 zu halten.

Im Übrigen gelten die obigen Erläuterungen im Zusammenhang mit den Figuren 1 und 4 bei dem Ausführungsbeispiel gemäß Figur 5 entsprechend.

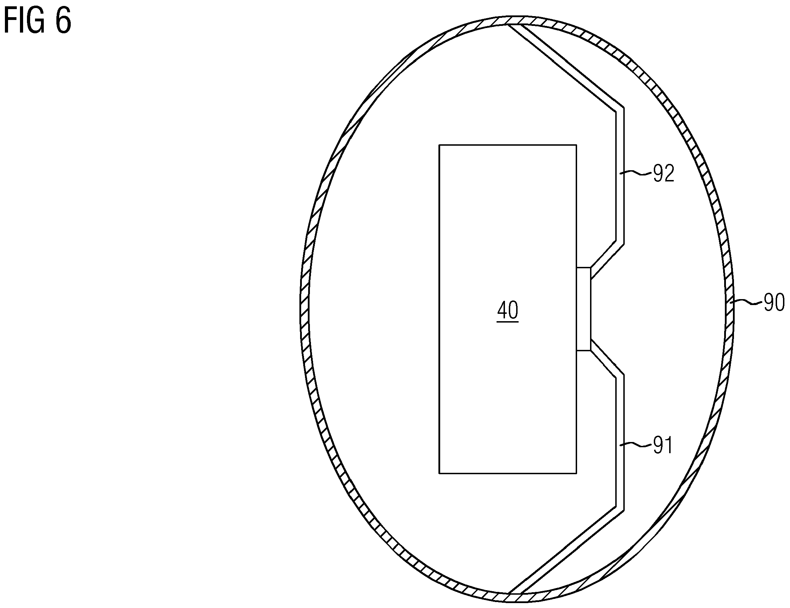

Die Figur 6 zeigt ein Ausführungsbeispiel für eine Abschirmeinrichtung 90, die im Querschnitt gesehen elliptisch oder zumindest annähernd zigarrenförmig ist und fachsprachlich eine "Korona-Zigarre" zur elektromagnetischen Abschirmung des Bereichs zwischen den beiden Leiterenden 11 und 21 bildet. Die Korona-Zigarre kann mittels zweier Tragarme 91 und 92 bei den Anordnungen gemäß den Figuren 1 und 5 beispielsweise an dem Gehäuse 40 angebracht werden. Alternativ ist es möglich, die Korona-Zigarre auch an einer der beiden Klemmeinrichtungen 31 oder 32 der Befestigungseinrichtung 30 anzubringen.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### Bezugszeichenliste

- 10: Leiterrohr
- 11: Leiterende
- 20: Leiterrohr
- 21: Leiterende
- 30: Befestigungseinrichtung
- 31: Klemmeinrichtung
- 31a: Klemmelement
- 31b: Gegenklemmelement
- 31c: Schellenverschraubung
- 32: Klemmeinrichtung
- 32a: Klemmelement
- 32b: Gegenklemmelement
- 32c: Schellenverschraubung
- 33: Halteelement
- 34: Anschlussschiene
- 35: Anschlussschiene
- 40: Gehäuse
- 50: Koaxialwiderstand
- 51: Widerstandsring
- 52: Stützelement
- 60: Sensorleitungen
- 70: Schnittstelle
- 80: Abschirmplatte
- 90: Abschirmeinrichtung
- 91: Tragarm
- 92: Tragarm
- 510: Hohlleiter
- 511: Hohlleiterabschnitt
- 512: Hohlleiterabschnitt
- 521: Abschnitt
- 522: Abschnitt
- 530: Hohlleiter
- 531: Ringelement
- 532: Endabschnitt
- 540: Anschlusselement
- 550: Anschlusselement
- 560: Spalt

- FK: Faradaykäfig
- I: Strom
- LWW: Lichtwellenleiter
- SE: elektrisches Messsignal
- SO: optisches Ausgangssignal

## Patentansprüche

1. Anordnung mit einem Koaxialwiderstand (50), wobei
- der Koaxialwiderstand (50) auf einem Gehäuse (40) aufgesetzt ist und Sensorleitungen (60) des Koaxialwiderstands (50) durch einen Innenraum des Koaxialwiderstands (50) hindurch in das Innere des Gehäuses (40) geführt sind und mit einer in dem Gehäuse (40) befindlichen elektrischen Schnittstelle (70) verbunden sind, **dadurch gekennzeichnet, dass**
- das Gehäuse elektrisch leitfähig ist,
- der Koaxialwiderstand (50) einen äußeren Hohlleiter (530) und einen in dem äußeren Hohlleiter (530) koaxial angeordneten und von diesem durch einen Spalt (560) getrennten inneren Hohlleiter (510) aufweist,
- der innere Hohlleiter (510) zumindest zwei Ringsegmente aufweist, von denen mindestens einer ein Widerstandsring (51) ist, der mit den Sensorleitungen (60) oder zumindest zwei der Sensorleitungen (60) in Verbindung steht.

2. Anordnung nach Anspruch 1,
**dadurch gekennzeichnet, dass**
der innere Hohlleiter (510) zumindest drei Ringsegmente aufweist, wobei einer von diesen ein gehäusenaher Hohlleiterabschnitt (512), einer ein gehäuseferner Hohlleiterabschnitt (511) und einer ein Widerstandsring (51) zwischen dem gehäusefernen und dem gehäusenahen Hohlleiterabschnitt.

3. Anordnung nach Anspruch 1 oder 2,
**dadurch gekennzeichnet, dass**
- ein innerer Abschnitt (521) eines Stützelements (52) des Koaxialwiderstands (50) ein Ringsegment des inneren Hohlleiters (510), insbesondere den gehäusenahen Hohlleiterabschnitt, bildet und
- ein äußerer Abschnitt (522) des Stützelements (52) ein äußeres Ringelement (531) des äußeren Hohlleiters (530) stützt.

4. Anordnung nach einem der voranstehenden Ansprüche,
**dadurch gekennzeichnet, dass**
der Koaxialwiderstand (50) auf dem Gehäuse (40) aufgeflanscht ist.

5. Anordnung nach einem der voranstehenden Ansprüche 3 bis 4,
**dadurch gekennzeichnet, dass**
ein Abschnitt des Stützelements (52) einen Flanschabschnitt bildet, der auf dem Gehäuse (40) aufgeflanscht ist.

6. Anordnung nach einem der voranstehenden Ansprüche,
**dadurch gekennzeichnet, dass**
ein oder mehrere Abschirmelemente, insbesondere eine oder mehrere Abschirmplatten (80), gemeinsam mit dem leitfähigen Gehäuse (40) und dem Koaxialwiderstand (50) einen Faradaykäfig (FK) zumindest auch für den Widerstandsring (52), die Sensorleitungen (60) und/oder die elektrische Schnittstelle (70) bilden.

7. Anordnung nach einem der voranstehenden Ansprüche,
**dadurch gekennzeichnet, dass**
der Koaxialwiderstand (50) und das Gehäuse (40) mittels einer Befestigungseinrichtung (30) zwischen einem ersten Leiterende (11) eines ersten Leiters einer Energieübertragungsleitung und einem dem ersten Leiterende gegenüber liegenden zweiten Leiterende (21) eines zweiten Leiters derselben Energieübertragungsleitung gehalten werden, wobei die Befestigungseinrichtung (30) mit einer ersten Klemmeinrichtung (31) an dem ersten Leiterende und mit einer zweiten Klemmeinrichtung (32) an dem zweiten Leiterende befestigt ist.

8. Anordnung nach Anspruch 7,
**dadurch gekennzeichnet, dass**
- die erste Klemmeinrichtung (31) ein erstes Klemmelement (31a) und ein erstes Gegenklemmelement (31b)aufweist, die das erste Leiterende umfassen und zwischen sich einklemmen, und
- die zweite Klemmeinrichtung (32) ein zweites Klemmelement (32a) und ein zweites Gegenklemmelement (32b) aufweist, die das zweite Leiterende umfassen und zwischen sich einklemmen.

9. Anordnung nach einem der voranstehenden Ansprüche,
**dadurch gekennzeichnet, dass**
der erste und zweite Leiter jeweils Leiterrohre (10, 20) sind, die im Bereich des ersten und zweiten Leiterendes koaxial zueinander angeordnet sind.

10. Anordnung nach einem der voranstehenden Ansprüche,
**dadurch gekennzeichnet, dass**
- die Befestigungseinrichtung (30) ein nichtleitendes Halteelement (33) aufweist, auf dem das Gehäuse (40) aufgesetzt ist, und
- der Koaxialwiderstand (50) von dem von der Befestigungseinrichtung (30) gehaltenen Gehäuse (40) zwischen den beiden Leiterenden gehalten wird.

11. Anordnung nach einem der voranstehenden Ansprüche,
**dadurch gekennzeichnet, dass**
- die Befestigungseinrichtung (30) mit einer ersten Anschlussschiene (34) an einen elektrischen Anschluss des Koaxialwiderstands (50) und mit einer zweiten Anschlussschiene (35) an den anderen elektrischen Anschluss des Koaxialwiderstands (50) angeschlossen ist, und
- die beiden Anschlussschienen der Befestigungseinrichtung (30) den Koaxialwiderstand (50) halten und der Koaxialwiderstand (50) das Gehäuse (40) hält.

12. Anordnung nach einem der voranstehenden Ansprüche,
**dadurch gekennzeichnet, dass**
eine elektrische Abschirmeinrichtung (90) gegen Koronaentladung den Koaxialwiderstand (50) und das Gehäuse (40) nach außen abschirmt.

13. Anordnung nach Anspruch 12,
**dadurch gekennzeichnet, dass**
die elektrische Abschirmeinrichtung (90) im Querschnitt elliptisch oder rund ist.

14. Anordnung nach einem der voranstehenden Ansprüche 12 bis 13,
**dadurch gekennzeichnet, dass**
die Längsachse der elektrischen Abschirmeinrichtung (90) koaxial zu den beiden Leiterrohren - zumindest im Bereich der einander gegenüber liegenden Leiterenden - angeordnet ist.

## Claims

1. Arrangement having a coaxial resistor (50), wherein
- the coaxial resistor (50) is placed on a housing (40), and
- sensor lines (60) of the coaxial resistor (50) are guided through an interior of the coaxial resistor (50) into the interior of the housing (40) and are connected to an electrical interface (70) in the housing (40), **characterized in that**
- the housing is electrically conductive,
- the coaxial resistor (50) has an outer waveguide (530) and an inner waveguide (510) which is arranged coaxially in the outer waveguide (530) and is separated from the latter by a gap (560),
- the inner waveguide (510) has at least two ring segments, at least one of which is a resistor ring (51) which is connected to the sensor lines (60) or to at least two of the sensor lines (60).

2. Arrangement according to Claim 1,
**characterized in that**
the inner waveguide (510) has at least three ring segments, wherein one of these is a waveguide section (512) close to the housing, one is a waveguide section (511) remote from the housing and one is a resistor ring (51) between the waveguide section remote from the housing and the waveguide section close to the housing.

3. Arrangement according to Claim 1 or 2,
**characterized in that**
- an inner section (521) of a supporting element (52) of the coaxial resistor (50) forms a ring segment of the inner waveguide (510), in particular the waveguide section close to the housing, and
- an outer section (522) of the supporting element (52) supports an outer ring element (531) of the outer waveguide (530).

4. Arrangement according to one of the preceding claims,
**characterized in that**
the coaxial resistor (50) is flanged onto the housing (40).

5. Arrangement according to one of the preceding Claims 3 to 4,
**characterized in that**
a section of the supporting element (52) forms a flange section which is flanged onto the housing (40).

6. Arrangement according to one of the preceding claims,
**characterized in that**
one or more shielding elements, in particular one or more shielding plates (80), form, together with the conductive housing (40) and the coaxial resistor (50), a Faraday cage (FK) at least also for the resistor ring (52), the sensor lines (60) and/or the electrical interface (70).

7. Arrangement according to one of the preceding claims,
**characterized in that**
the coaxial resistor (50) and the housing (40) are held, by means of a fastening device (30), between a first conductor end (11) of a first conductor of an energy transmission line and a second conductor end (21) of a second conductor of the same energy transmission line, which second conductor end is opposite the first conductor end, wherein the fastening device (30) is fastened using a first clamping device (31) at the first conductor end and using a second clamping device (32) at the second conductor end.

8. Arrangement according to Claim 7,
**characterized in that**
- the first clamping device (31) has a first clamping element (31a) and a first mating clamping element (31b) which surround the first conductor end and clamp it between them, and
- the second clamping device (32) has a second clamping element (32a) and a second mating clamping element (32b) which surround the second conductor end and clamp it between them.

9. Arrangement according to one of the preceding claims,
**characterized in that**
the first and second conductors are each conductor tubes (10, 20) which are arranged in a coaxial manner with respect to one another in the region of the first and second conductor ends.

10. Arrangement according to one of the preceding claims,
**characterized in that**
- the fastening device (30) has a non-conductive holding element (33) on which the housing (40) is placed, and
- the coaxial resistor (50) is held between the two conductor ends by the housing (40) held by the fastening device (30).

11. Arrangement according to one of the preceding claims,
**characterized in that**
- the fastening device (30) is connected to one electrical connection of the coaxial resistor (50) using a first connecting rail (34) and is connected to the other electrical connection of the coaxial resistor (50) using a second connecting rail (35), and
- the two connecting rails of the fastening device (30) hold the coaxial resistor (50) and the coaxial resistor (50) holds the housing (40).

12. Arrangement according to one of the preceding claims,
**characterized in that**
an electrical shielding device (90) for a corona discharge externally shields the coaxial resistor (50) and the housing (40).

13. Arrangement according to Claim 12,
**characterized in that**
the electrical shielding device (90) has an elliptical or round cross section.

14. Arrangement according to one of the preceding Claims 12 to 13,
**characterized in that**
the longitudinal axis of the electrical shielding device (90) is arranged in a coaxial manner with respect to the two conductor tubes, at least in the region of the conductor ends which are opposite one another.

## Revendications

1. Agencement à résistance ( 50 ) coaxiale, dans lequel
- la résistance ( 50 ) coaxiale est mise sur un boîtier ( 40 ) et
des lignes ( 60 ) de capteur de la résistance ( 50 ) coaxiale passent à l'intérieur du boîtier ( 40 ), en passant dans un espace intérieur de la résistance ( 50 ) coaxiale et sont reliées à une interface ( 70 ) électrique se trouvant dans le boîtier ( 40 ), **caractérisé en ce que**
- le boîtier est conducteur de l'électricité,
- la résistance ( 50 ) coaxiale a un conducteur ( 530 ) extérieur creux et un conducteur ( 510 ) intérieur creux disposé coaxialement dans le conducteur ( 530 ) extérieur creux et séparé de celui-ci par un intervalle ( 560 ),
- le conducteur ( 510 ) intérieur creux a au moins deux segments annulaires, dont l'un au moins est un anneau ( 51 ) de résistance, qui est en liaison avec les lignes ( 60 ) du capteur ou avec au moins deux des lignes ( 60 ) du capteur.

2. Agencement suivant la revendication 1,
**caractérisé en ce que**
le conducteur ( 510 ) intérieur creux a au moins trois segments annulaires, l'un d'entre eux étant une partie ( 512 ) de conducteur creux proche du boîtier, l'un une partie ( 511 ) de conducteur creux loin du boîtier et l'un un anneau ( 51 ) de résistance entre la partie de conducteur creux loin du boîtier et la partie de conducteur creux proche du boîtier.

3. Agencement suivant la revendication 1 ou 2,
**caractérisé en ce que**
- une partie ( 521 ) intérieure d'un élément ( 52 ) d'appui de la résistance coaxiale forme un segment annulaire du conducteur ( 510 ) intérieur creux, notamment de la partie du conducteur creux proche du boîtier et
- une partie ( 522 ) extérieure de l'élément ( 52 ) d'appui appuie un élément ( 531 ) annulaire extérieur du conducteur ( 530 ) extérieur creux.

4. Agencement suivant l'une des revendications précédentes,
**caractérisé en ce que**
la résistance ( 50 ) coaxiale est bridée sur le boîtier ( 40 ).

5. Agencement suivant l'une des revendications 3 à 4 précédentes,
**caractérisé en ce qu'**
une partie de l'élément ( 52 ) d'appui forme une partie de bride, qui est bridée sur le boîtier ( 40 ).

6. Agencement suivant l'une des revendications précédentes,
**caractérisé en ce qu'**
un ou plusieurs éléments de blindage, notamment une ou plusieurs plaques ( 80 ) de blindage, forment, conjointement avec le boîtier ( 40 ) conducteur et la résistance ( 50 ) coaxiale, une cage ( FK ) de Faraday, au moins également pour l'anneau ( 52 ) de résistance, les lignes ( 60 ) du capteur et/ou l'interface ( 70 ) électrique.

7. Agencement suivant l'une des revendications précédentes,
**caractérisé en ce que**
la résistance ( 50 ) coaxiale et le boîtier ( 40 ) sont maintenus au moyen d'un dispositif ( 30 ) de fixation entre un premier bout ( 11 ) d'un premier conducteur d'une ligne de transport d'énergie et un deuxième bout ( 21 ), opposé au premier bout, d'un deuxième conducteur de la même ligne de transport d'énergie, le dispositif ( 30 ) de fixation étant fixé par un premier dispositif ( 31 ) de serrage au premier bout du conducteur et par un deuxième dispositif ( 32 ) de serrage au deuxième bout du conducteur.

8. Agencement suivant la revendication 7,
**caractérisé en ce que**
- le premier dispositif ( 31 ) de serrage a un premier élément ( 31a ) de serrage et un premier contre-élément ( 31b ) de serrage, qui entourent le premier bout du conducteur et le serrent entre eux, et
- le deuxième dispositif ( 32 ) de serrage a un deuxième élément ( 32a ) de serrage et un deuxième contre-élément ( 32b ) de serrage, qui entourent le deuxième bout du conducteur et le serrent entre eux.

9. Agencement suivant l'une des revendications précédentes,
**caractérisé en ce que**
le premier et le deuxième conducteurs sont, respectivement, des tubes ( 10 ; 20 ) conducteurs, qui sont disposés coaxialement entre eux dans la partie du premier et du deuxième bouts du conducteur.

10. Agencement suivant l'une des revendications précédentes,
**caractérisé en ce que**
- le dispositif ( 30 ) de fixation a un élément ( 33 ) de maintien non conducteur, sur lequel est mis le boîtier ( 40 ), et
- la résistance ( 50 ) coaxiale est maintenue, entre les deux bouts du conducteur, par le boîtier ( 40 ) maintenu par le dispositif ( 30 ) de fixation.

11. Agencement suivant l'une des revendications précédentes,
**caractérisé en ce que**
- le dispositif ( 30 ) de fixation est raccordé, par une première barre ( 34 ) de connexion, à une borne électrique de la résistance ( 50 ) coaxiale et, par une deuxième barre ( 35 ) de connexion, à l'autre borne électrique de la résistance ( 50 ) coaxiale, et
- les deux barres de connexion du dispositif ( 30 ) de fixation maintiennent la résistance ( 50 ) coaxiale et la résistance ( 50 ) coaxiale maintient le boîtier ( 40 ).

12. Agencement suivant l'une des revendications précédentes,
**caractérisé en ce qu'**
un dispositif ( 90 ) de blindage électrique protège, vers l'extérieur, à l'encontre de la décharge couronne, la résistance ( 50 ) coaxiale et le boîtier ( 40 ).

13. Agencement suivant la revendication 12,
**caractérisé en ce que**
le dispositif ( 50 ) de blindage électrique est, en section transversale, elliptique ou circulaire.

14. Agencement suivant l'une des revendications 12 à 13 précédentes,
**caractérisé en ce que**
l'axe longitudinal du dispositif ( 90 ) de blindage électrique est coaxial aux deux tubes conducteurs - au moins dans la partie des bouts de conducteur opposés l'un à l'autre.
